# EUROPEAN PATENT APPLICATION

(11) **EP 4 787 435 A1**
(43) Date of publication of application: **05.08.2026**
(21) Application number: 24910658.4
(22) Date of filing: 09.12.2024
(51) Int. Cl.: H01L 23/367

(54) **POWER ASSEMBLY AND ELECTRIC MOTOR CONTROLLER**

(30) Priority: 28.12.2023 CN 202311836128
(71) Applicant: Huawei Digital Power Technologies Co., Ltd., Shenzhen, Guangdong 518043 (CN)
(72) Inventor: TANG, Qingguo, Shenzhen, Guangdong 518043 (CN); CHENG, Zhao, Shenzhen, Guangdong 518043 (CN); LIU, Wei, Shenzhen, Guangdong 518043 (CN); LIU, Guoqiang, Shenzhen, Guangdong 518043 (CN)
(74) Representative: Maiwald GmbH
(86) International application number: PCT/CN2024/137768
(87) International publication number: WO 2025/139727

(57) **Abstract**

This application provides a power assembly and a motor controller. The power assembly includes a power module, a heat sink, and an insulation member. The power module includes a lead-out terminal. The insulation member is disposed on a surface of a side that is of the heat sink and that faces the power module. In a thickness direction of the power assembly, a projection of the insulation member covers a projection of the lead-out terminal on the heat sink. In a thickness direction of the power assembly, a projection of the insulation member covers a projection of the lead-out terminal on the heat sink, which ensures safety electrical insulation between the lead-out terminal and the heat sink through the insulation member, thereby improving electrical insulation performance between the power module and the heat sink.

## Description

This application claims priority to Chinese Patent Application No. 202311836128.7, filed with the China National Intellectual Property Administration on December 28, 2023 and entitled "POWER ASSEMBLY AND MOTOR CONTROLLER", which is incorporated herein by reference in its entirety.

### TECHNICAL FIELD

This application relates to the field of new energy technologies, and in particular, to a power assembly and a motor controller.

### BACKGROUND

In new energy vehicles, insulated gate bipolar transistors (insulated gate bipolar transistors, IGBTs) or silicon carbide SiC power modules are power conversion core components for the new energy vehicles. As products continuously develop toward high voltages, high efficiency, and high power density, heat consumption density is continuously increasing. This requires reducing thermal resistance of an entire link from a chip to a heat sink and improving a heat dissipation capability of a power module, to dissipate, in a timely manner, heat generated by the chips. Usually, a heat dissipation manner of the power module is water cooling. An interface material such as thermal grease is filled between a water-cooled heat sink and the power module. An additional screw is required for installation and fastening between the heat sink and the power module, and electrical insulation between the heat sink and the power module is poor.

### SUMMARY

A technical problem to be resolved in embodiments of this application is to provide a power assembly and a motor controller that help improve electrical insulation performance.

According to a first aspect, this application provides a power assembly, including a power module, a heat sink, and an insulation member. The power module includes a lead-out terminal. The insulation member is disposed on a surface of a side that is of the heat sink and that faces the power module. In a thickness direction of the power assembly, a projection of the insulation member covers a projection of the lead-out terminal on the heat sink.

The insulation member is disposed on the surface of the heat sink. In the thickness direction of the power assembly, the projection of the insulation member covers the projection of the lead-out terminal on the heat sink. This ensures safety electrical insulation between the lead-out terminal and the heat sink through the insulation member, thereby improving electrical insulation performance between the power module and the heat sink.

With reference to the first aspect, in a possible implementation, the insulation member includes a bottom plate and a positioning portion. One end of the positioning portion is connected to the bottom plate, the other end of the positioning portion extends in a direction away from the bottom plate, and the bottom plate and the lead-out terminal are disposed opposite to each other in the thickness direction of the power assembly. The positioning portion and the bottom plate enclose an accommodating groove, and the accommodating groove accommodates at least a part of the power module.

In this possible implementation, in the thickness direction of the power assembly, the bottom plate is located between the lead-out terminal and the heat sink, and the bottom plate is disposed to ensure electrical insulation between the lead-out terminal and the heat sink. In addition, the bottom plate and the positioning portion enclose the accommodating groove, and at least a part of the power module is accommodated in the accommodating groove, so that the insulation member is used to position the power module as a whole. This improves installation efficiency of the power module and the heat sink.

With reference to the first aspect, in a possible implementation, the heat sink includes a heat dissipation substrate and a boss, the boss protrudes from a surface of a side that is of the heat dissipation substrate and that faces the power module, and the bottom plate is disposed on the surface of the side that is of the heat dissipation substrate and that faces the power module and is located on two opposite sides of the boss.

In this possible implementation, the boss is disposed on the surface of the side that is of the heat sink and that faces the power module. An electrical distance between the heat dissipation substrate and the power module is increased through arrangement of the boss, to ensure electrical insulation between the heat dissipation substrate and the lead-out terminal. The bottom plate is disposed on the two opposite sides of the boss, and the bottom plate may be used to electrically insulate a part that is of the heat dissipation substrate and on which no boss is disposed from the lead-out terminal.

With reference to the first aspect, in a possible implementation, in an arrangement direction of the heat dissipation substrate and the boss, a thickness of the insulation member is less than a height of the boss.

In this possible implementation, the thickness of the insulation member is less than the height of the boss, so that a part of the boss can extend into the accommodating groove enclosed by the insulation member. This facilitates connection between a surface of a side that is of the boss and that faces the power module and the power module in the accommodating groove.

With reference to the first aspect, in a possible implementation, the power assembly further includes a package body, the package body wraps the power module, and at least a part of the package body is located in the accommodating groove.

In this possible implementation, the package body seals the power module, thereby preventing external water vapor from entering the power module, and avoiding a short circuit phenomenon of the power module. At least a part of the package body is located in the accommodating groove, so that the insulation member positions the package body and the power module in the package body.

With reference to the first aspect, in a possible implementation, a protruding portion is formed on an outer edge of the package body. In an arrangement direction of the boss and the bottom plate, the protruding portion protrudes along a side away from the boss, and a spacing between the boss and the bottom plate is less than or equal to a length of the protruding portion protruding along the side away from the boss.

In this possible implementation, when the spacing between the boss and the bottom plate is equal to the length of the protruding portion protruding along the side away from the boss, the protruding portion and the bottom plate together implement electrical insulation for the lead-out terminal and the heat sink. In the thickness direction of the power assembly, a projection of the bottom plate on the heat sink does not overlap with a projection of the protruding portion on the heat sink. This reduces arrangement of the bottom plate and effectively reduces manufacturing costs. When the spacing between the boss and the bottom plate is less than the length of the protruding portion protruding along the side away from the boss, in the thickness direction of the power assembly, the projection of the bottom plate on the heat sink overlaps the projection of the protruding portion on the heat sink, to enhance electrical insulation performance between the lead-out terminal and the heat sink.

With reference to the first aspect, in a possible implementation, the power module includes a chip and a thermally conductive substrate, the chip is disposed on a side that is of the thermally conductive substrate and that is away from the heat sink, a surface of a side that is of the thermally conductive substrate and that faces the sintered layer is exposed from the package body, and the sintered layer is fastened between the thermally conductive substrate and the boss.

In this possible implementation, the surface of the side that is of the thermally conductive substrate and that faces the sintered layer is exposed from the package body. This eliminates blocking of the package body, and facilitates connection between the sintered layer and the surface of the side that is of the thermally conductive substrate and that faces the sintered layer.

With reference to the first aspect, in a possible implementation, in the thickness direction of the power assembly, a projected area of the boss is less than or equal to a projected area of the thermally conductive substrate.

In this possible implementation, the package body is disposed on an outer edge of the thermally conductive substrate, and a surface of a side that is of the package body and that faces the heat sink and a surface of a side that is of the thermally conductive substrate and that faces the heat sink are basically on a same surface. When the boss is connected to the thermally conductive substrate, if the projected area of the boss is greater than the projected area of the thermally conductive substrate, a part of the boss that exceeds the thermally conductive substrate squeezes the package body, and damages sealing of the power module by the package body. If the projected area of the boss is less than or equal to the projected area of the thermally conductive substrate, when the boss is connected to the thermally conductive substrate, squeezing on the package body can be reduced, and sealing of the power module by the package body can be ensured.

With reference to the first aspect, in a possible implementation, the thermally conductive substrate includes a first thermally conductive layer, a thermally conductive insulation layer, and a second thermally conductive layer that are sequentially stacked, and a material for manufacturing the thermally conductive insulation layer includes a thermally conductive insulation sheet or a thermally conductive insulation film.

In this possible implementation, the material for manufacturing the thermally conductive insulation layer is the thermally conductive insulation sheet. The thermally conductive insulation sheet has a good thermal conductivity, thereby helping improve an overall heat dissipation capability of the power module. Alternatively, the material for manufacturing the thermally conductive insulation layer is the thermally conductive insulation film. The thermally conductive insulation film has good toughness, thereby helping improve overall reliability of the thermally conductive substrate.

With reference to the first aspect, in a possible implementation, the thermally conductive substrate includes a first thermally conductive substrate and a second thermally conductive substrate, the first thermally conductive substrate and the second thermally conductive substrate are respectively disposed on two opposite sides of the chip, and the first thermally conductive substrate and/or the second thermally conductive substrate are/is connected to the boss through the sintered layer.

In this possible implementation, the first thermally conductive substrate and the second thermally conductive substrate are respectively disposed on the two opposite sides of the chip for heat dissipation. This increases a heat dissipation area of the power module and improves heat dissipation efficiency of the power module. At least one of the first thermally conductive substrate and the second thermally conductive substrate is connected to the boss through the sintered layer, that is, at least one of the first thermally conductive substrate and the second thermally conductive substrate is connected to the heat sink through the sintered layer, to further improve heat dissipation efficiency and a heat dissipation capability of the power module.

With reference to the first aspect, in a possible implementation, the heat sink includes a first heat sink and a second heat sink, the first heat sink includes a first heat dissipation substrate and a first boss, and the second heat sink includes a second heat dissipation substrate and a second boss. The first heat dissipation substrate and the second heat dissipation substrate are located on the two opposite sides of the chip, the first boss protrudes from a surface of a side that is of the first heat dissipation substrate and that faces the chip, and the second boss protrudes from a surface of a side that is of the second heat dissipation substrate and that faces the chip. The sintered layer includes a first sintered layer and a second sintered layer, the first sintered layer is fastened between the first boss and the first thermally conductive substrate, and the second sintered layer is fastened between the second boss and the second thermally conductive substrate.

In this possible implementation, the first heat sink and the second heat sink are respectively disposed on the two opposite sides of the chip. This improves heat dissipation efficiency and a heat dissipation capability of the power module. In addition, the first boss is disposed on the first heat sink, and the second boss is disposed on the second heat sink. This increases an electrical distance between the first heat sink and the power module as well as an electrical distance between the second heat sink and the power module, ensures electrical insulation between the first heat sink and the lead-out terminal as well as electrical insulation between the second heat sink and the lead-out terminal. In addition, no additional screw is required for fastening between the first heat sink and the power module and for fastening between the second heat sink and the power module. This simplifies an installation process, implements integration between the power module and the first heat sink as well as integration between the power module and the second heat sink, reduces thermal resistance of an interface, and improves a heat dissipation capability of the power module.

With reference to the first aspect, in a possible implementation, the insulation member includes a first insulation member and a second insulation member, the first insulation member is disposed on a surface of a side that is of the first heat sink and that faces the second heat sink, the second insulation member is disposed on a surface of a side that is of the second heat sink and that faces the first heat sink, and a positioning portion is disposed on the first insulation member or the second insulation member.

In this possible implementation, the positioning portion is disposed on one of the first insulation member and the second insulation member, and the power module is positioned by using the positioning portion of one of the insulation members. This reduces manufacturing costs of the insulation member.

With reference to the first aspect, in a possible implementation, a chamfer is disposed on an outer edge of the boss.

In this possible implementation, when the boss is connected to the sintered layer, an excessive part of the sintered layer may flow from the chamfer to a side of the boss, to prevent the excessive part of the sintered layer from flowing to the power module, and reduce impact of sintered connection on the power module. In addition, the chamfer is disposed to allow for a thicker weld at an edge at which the boss is connected to the sintered layer, thereby improving reliability of connection between the boss and the sintered layer.

According to a second aspect, a motor controller includes a capacitor and the power assembly provided in any implementation of the first aspect. A lead-out terminal of a power module is connected to a thermally conductive substrate of the power module, the capacitor is connected to the power module through the lead-out terminal, and the capacitor is configured to provide a voltage for the power module.

The power assembly according to the first aspect is used. The power assembly has better electrical insulation performance and a better heat dissipation capability, so that the motor controller can have a higher current output capability under a same voltage, thereby improving power conversion efficiency of the motor controller. In the power module, integration between the power module and the heat sink is implemented through the sintered layer, so that a size of the motor controller can be correspondingly reduced, thereby improving power density of the motor controller.

According to a third aspect, a powertrain includes a motor and the motor controller provided in the second aspect. The motor is connected to the motor controller.

The motor controller according to the second aspect is used. The motor controller has a higher current output capability, a smaller size, and a reduced weight, so that output power and power density of the powertrain can be increased, and higher electric energy can be provided for the motor. This enables the motor to output higher kinetic energy, and the powertrain to have a higher driving force.

According to a fourth aspect, a vehicle includes a wheel and the powertrain provided in the third aspect. The powertrain is connected to the wheel, and the powertrain is configured to provide power for the wheel.

The powertrain according to the third aspect is used. The powertrain can provide a higher driving force, so that the vehicle has greater power, thereby providing better driving experience for a driver.

### BRIEF DESCRIPTION OF DRAWINGS

To describe the technical solutions in embodiments of this application or in the background more clearly, the following briefly describes the accompanying drawings for describing embodiments of this application or the background.
FIG. 1 is a diagram of a structure of a vehicle according to an embodiment of this application;
FIG. 2 is a diagram of a powertrain according to an embodiment of this application;
FIG. 3 is a diagram of a structure of a power assembly of a single-sided heat dissipation structure according to an embodiment of this application;
FIG. 4 is an enlarged diagram of the power assembly shown in FIG. 3 at a position IV;
FIG. 5 is a diagram of a structure of a power assembly of another single-sided heat dissipation structure according to an embodiment of this application;
FIG. 6 is a diagram of a structure of a power assembly of still another single-sided heat dissipation structure according to an embodiment of this application;
FIG. 7 is a diagram of a structure of a power assembly of a double-sided heat dissipation structure according to an embodiment of this application;
FIG. 8 is a diagram of a structure of a power assembly of another double-sided heat dissipation structure according to an embodiment of this application; and
FIG. 9 is a diagram of a structure of a power assembly of still another double-sided heat dissipation structure according to an embodiment of this application.

Reference numerals:
power assembly: 100; power module: 10; thermally conductive substrate: 11; first thermally conductive substrate: 11a; second thermally conductive substrate: 11b; first thermally conductive layer: 111; thermally conductive insulation layer: 112; second thermally conductive layer: 113; chip: 12; lead-out terminal: 13; interconnection column: 14; sintered layer: 20; first sintered layer: 20a; second sintered layer: 20b; insulation member: 30; first insulation member: 30a; second insulation member: 30b; bottom plate: 31; positioning portion: 32; through hole: 33; accommodating groove: 34; heat sink: 40; first heat sink: 40a; second heat sink: 40b; heat dissipation substrate: 41; first heat dissipation substrate: 41a; second heat dissipation substrate: 41b; heat dissipation fin: 42; housing: 43; boss: 44; first boss: 44a; second boss: 44b; chamfer: 441; heat dissipation waterway: 45; package body: 50; protruding portion: 51; motor controller: 210; capacitor: 2101; motor: 220; powertrain: 200; wheel: 300; vehicle: 1000.

### DESCRIPTION OF EMBODIMENTS

To make the objectives, technical solutions, and advantages of this application clearer, the following further describes this application in detail with reference to the accompanying drawings.

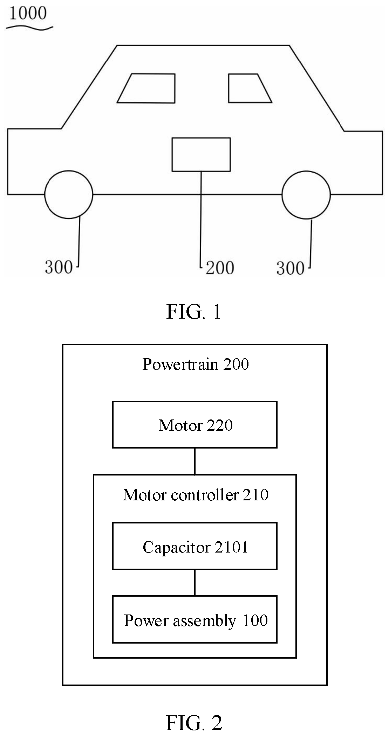

FIG. 1 is a diagram of a structure of a vehicle 1000 according to an embodiment of this application. The vehicle 1000 includes a wheel 300 and a powertrain 200 provided in this application. The powertrain 200 is connected to the wheel 300, and the powertrain 200 is configured to provide power for the wheel 300, to drive the wheel 300 to move forward or backward. In this application, the vehicle 1000 may be an electric vehicle (EV), a pure electric vehicle (PEV/BEV), a hybrid electric vehicle (HEV), a range-extended electric vehicle (REEV), a plug-in hybrid electric vehicle (PHEV), a new energy vehicle (New Energy Vehicle), or the like.

FIG. 2 is a diagram of a powertrain 200 according to an embodiment of this application. The powertrain 200 includes a motor 220 and a motor controller 210 provided in this application. The motor controller 210 is connected to the motor 220. The motor controller 210 controls a direct current in a power supply of the vehicle 1000 to be converted into an alternating current, to drive the motor 220 to rotate. The wheel 300 moves under driving of the motor 220, to drive the vehicle 1000 to move forward or backward.

The motor controller 210 includes a capacitor 2101 and a power assembly 100 provided in this application.

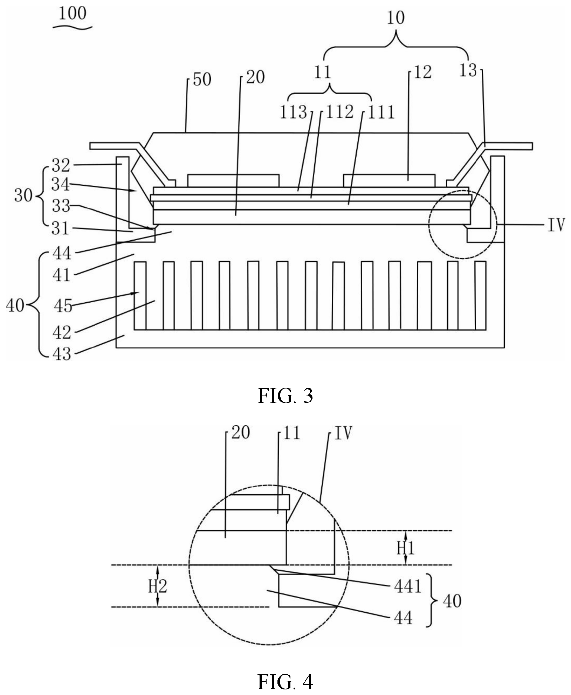

FIG. 3 is a diagram of a structure of a power assembly 100 of a single-sided heat dissipation structure according to an embodiment of this application. As shown in FIG. 3, the power assembly 100 includes a power module 10, a sintered layer 20, a heat sink 40, an insulation member 30, and a package body 50. The power module 10, the sintered layer 20, and the heat sink 40 are sequentially stacked. The sintered layer 20 is fastened between the power module 10 and the heat sink 40. The heat sink 40 is fastened to the power module 10 through arrangement of the sintered layer 20, so that no additional screw is required for fastening between the power module 10 and the heat sink 40. This simplifies an installation process between the power module 10 and the heat sink 40. The power module 10 is directly connected to the heat sink 40 through the sintered layer 20, so that the power module 10 and the heat sink 40 are integrated. This reduces interface thermal resistance, and improves a heat dissipation capability of the power module 10. Silicone grease is replaced with the sintered layer 20 with high heat conductivity, to further reduce the interface thermal resistance and improve the heat dissipation capability of the power module 10. The insulation member 30 is disposed on a surface of a side that is of the heat sink 40 and that faces the power module 10. This ensures safety electrical insulation between the power module 10 and the heat sink 40 through the insulation member 30, thereby improving electrical insulation performance between the power module 10 and the heat sink 40. The package body 50 wraps the power module 10, so that the power module 10 is sealed, thereby preventing external water vapor from entering the power module 10, and avoiding a short circuit phenomenon of the power module 10.

The power module 10 includes a thermally conductive substrate 11, a chip 12, and a lead-out terminal 13. Both the chip 12 and the lead-out terminal 13 are disposed on a side that is of the thermally conductive substrate 11 and that is away from the heat sink 40. The lead-out terminal 13 is configured to connect a capacitor 2101 to the thermally conductive substrate 11, so that the capacitor 2101 provides a voltage for the power module 10. The surface of the side that is of the thermally conductive substrate 11 and that faces the sintered layer 20 is exposed from the package body 50. This eliminates blocking of the package body 50, and facilitates connection between the sintered layer 20 and the surface of the side that is of the thermally conductive substrate 11 and that faces the sintered layer 20.

The power module 10 is of a single-sided heat dissipation structure, and a heat sink 40 is disposed on a side of a thickness direction of the power module 10, to reduce an overall size of the power assembly 100. As shown in FIG. 3, there is one power module 10, and the power module 10 is a plastic-packaged power module, for example, a plastic-packaged IGBT or SiC power module.

There may be one or more chips 12. When there are a plurality of chips 12, the plurality of chips 12 are disposed on the thermally conductive substrate 11 at intervals, and lead-out terminals 13 are disposed at two opposite ends of the plurality of chips 12.

One end of the lead-out terminal 13 is connected to the thermally conductive substrate 11, the other end of the lead-out terminal 13 is exposed from the package body 50, and a part of the lead-out terminal 13 exposed from the package body 50 extends in a length direction of the power assembly 100 to connect to the capacitor 2101. Optionally, the lead-out terminal 13 may further extend in a thickness direction of the power assembly 100.

A coating may be applied to the surface of the thermally conductive substrate 11. Specifically, the coating may be applied to the surface of the thermally conductive substrate 11 by using a method such as chemical plating or electroplating. A coating material may be any one of Sn, Ag, or Au.

The thermally conductive substrate 11 includes a first thermally conductive layer 111, a thermally conductive insulation layer 112, and a second thermally conductive layer 113 that are sequentially stacked. A surface of a side that is of the first thermally conductive layer 111 and that faces the sintered layer 20 is exposed from the package body 50. Both the first thermally conductive layer 111 and the second thermally conductive layer 113 are metal thermally conductive layers. For example, both the first thermally conductive layer 111 and the second thermally conductive layer 113 are metal copper, metal aluminum, or another thermally conductive material. Materials for manufacturing the first thermally conductive layer 111 and the second thermally conductive layer 113 may be the same or may be different. This is not specifically limited. The material for manufacturing the thermally conductive insulation layer 112 includes a thermally conductive insulation sheet or a thermally conductive insulation film, where the thermally conductive insulation sheet may be ceramic, for example, Al2O3, Si3N4, or AlN. The thermally conductive insulation sheet has a good thermal conductivity, thereby helping improve a heat dissipation capability of the power module 10. The thermally conductive insulation film is thin and has good toughness, thereby helping improve overall reliability of the thermally conductive substrate 11.

The first thermally conductive layer 111 is fastened to the sintered layer 20, and the second thermally conductive layer 113 is connected to the chip 12 and the lead-out terminal 13. Heat generated by the chip 12 and the lead-out terminal 13 is conducted to the thermally conductive insulation layer 112 through the second thermally conductive layer 113, and then is conducted to the first thermally conductive layer 111 from the thermally conductive insulation layer 112, and is further conducted to the outside of the power assembly 100 through the sintered layer 20 and the heat sink 40.

Refer to FIG. 4. In an arrangement direction of the sintered layer 20 and the heat sink 40, a thickness of the sintered layer 20 is greater than or equal to 50 µm and less than or equal to 300 µm. For example, the thickness of the sintered layer 20 may be denoted as H1, and a value of the thickness H1 of the sintered layer 20 may be 50 µm, 75 µm, 125 µm, 140 µm, 160 µm, 180 µm, 230 µm, 250 µm, 275 µm, or 300 µm, which is not listed one by one.

If the thickness of the sintered layer 20 is less than 50 µm, the thickness of the sintered layer 20 is excessively small, and reliability of sintered connection between the sintered layer 20 and the heat sink 40 and between the sintered layer 20 and the power module 10 is low. If the thickness of the sintered layer 20 is greater than 300 µm, the thickness of the sintered layer 20 is excessively large, which increases manufacturing costs of the power assembly 100 and causes an increase in thermal resistance between the power module 10 and the heat sink 40. In this application, the thickness of the sintered layer 20 is set to be greater than or equal to 50 µm and less than or equal to 300 µm, so that reliability of connection between the sintered layer 20 and the heat sink 40 and between the sintered layer 20 and the power module 10 is higher, and thermal resistance between the power module 10 and the heat sink 40 is reduced. This enables heat generated by the power module 10 to be more quickly conducted to the heat sink 40, improves a heat dissipation capability of the power module 10, and effectively reduces manufacturing costs of the power assembly 100.

A material for manufacturing the sintered layer 20 includes any one of sintered silver, sintered copper, sintered copper silver, or all-IMC solder, to reduce manufacturing costs of the sintered layer 20, thereby reducing manufacturing costs of the power assembly 100. Preferably, the material for manufacturing the sintered layer 20 is sintered silver, and may be specifically determined based on a heat dissipation requirement and process costs.

The all-IMC solder includes at least two alloy components with different melting points, and each alloy component includes one or more of Cu, Sn, Ag, Ni, Bi, In, Sb, Co, Au, Zn, and Cd. For example, the alloy components include Cu and Sb, or the alloy components include Ag, Bi, and Co. For another example, the alloy components include Cu, or the alloy components include Sn and Bi. In this way, a melting point of the all-IMC solder is low, thereby reducing a sintering temperature. The alloy components may be other combinations, which are not listed one by one.

In an implementation, in the thickness direction of the power assembly 100, a projected area of the sintered layer 20 is less than or equal to a projected area of the thermally conductive substrate 11. The package body 50 is disposed on an outer edge of the thermally conductive substrate 11, and a surface of a side that is of the package body 50 and that faces the heat sink 40 and a surface of a side that is of the thermally conductive substrate 11 and that faces the heat sink 40 are basically on a same surface. When the sintered layer 20 is sintered, pressure needs to be applied to the sintered layer 20. If the projected area of the sintered layer 20 is greater than the projected area of the thermally conductive substrate 11, a part of the sintered layer 20 that exceeds the thermally conductive substrate 11 squeezes the package body 50, and damages sealing of the power module 10 by the package body 50. If the projected area of the sintered layer 20 is less than or equal to the projected area of the thermally conductive substrate 11, when pressure is applied to the sintered layer 20, squeezing on the package body 50 can be reduced, and sealing of the power module 10 by the package body 50 can be ensured.

For example, the insulation member 30 is placed on an outer edge of the heat sink 40, and is fastened to the heat sink 40 through a bolt. A position of the bolt is staggered with a position of the lead-out terminal 13. For example, in the thickness direction of the power assembly 100, a projection of the lead-out terminal 13 is staggered with a projection of the bolt, to reduce impact of the bolt on electrical insulation of the power assembly 100. Optionally, the insulation member 30 may be further connected to the heat sink 40 in a manner of adhesive bonding or pin fastening. This is not specifically limited.

A material for manufacturing the insulation member 30 may be rubber, resin, plastic, or another insulating material.

In the thickness direction of the power assembly 100, a projection of the insulation member 30 covers a projection of the lead-out terminal 13 on the heat sink 40. In other words, in the thickness direction of the power assembly 100, the insulation member 30 is disposed between the lead-out terminal 13 and the outer edge of the heat sink 40, so that the insulation member 30 can separate the lead-out terminal 13 from the heat sink 40 in the thickness direction of the power assembly 100, thereby ensuring safety electrical insulation between the lead-out terminal 13 and the heat sink 40.

In the thickness direction of the power assembly 100, in a part that is between the lead-out terminal 13 and the heat sink 40 and that is not separated by the thermally conductive substrate 11 and the sintered layer 20, the projection of the insulation member 30 covers the projection of the lead-out terminal 13 on the heat sink 40.

In an implementation, for the insulation member 30, a comparative tracking index (comparative tracking index, CTI) is greater than or equal to 150, a breakdown voltage is greater than or equal to 4.2 kV, and a short-time temperature resistance temperature is greater than or equal to 210°C. This ensures safety electrical insulation between the lead-out terminal 13 and the heat sink 40 through the insulation member 30.

The insulation member 30 includes a bottom plate 31 and a positioning portion 32. One end of the positioning portion 32 is connected to the bottom plate 31, and the other end of the positioning portion 32 extends in a direction away from the bottom plate 31. The positioning portion 32 is fastened to two opposite end parts of the bottom plate 31, and the positioning portion 32 is integrated with the bottom plate 31, thereby eliminating the need for an installation process for the bottom plate 31 and the positioning portion 32. The bottom plate 31 and the lead-out terminal 13 are disposed opposite to each other in the thickness direction of the power assembly 100. The positioning portion 32 and the bottom plate 31 enclose an accommodating groove 34, and the accommodating groove 34 accommodates the sintered layer 20 and at least a part of the power module 10.

In the thickness direction of the power assembly 100, a projection of the bottom plate 31 is greater than a projection of the heat sink 40, so that the lead-out terminal 13 is separated from the heat sink 40 through the bottom plate 31, thereby ensuring electrical insulation between the lead-out terminal 13 and the heat sink 40. Optionally, in the thickness direction of the power assembly 100, the projection of the bottom plate 31 is equal to the projection of the heat sink 40, thereby reducing space occupied by the bottom plate 31.

A through hole 33 is formed on the bottom plate 31, and a part of the heat sink 40 passes through the through hole 33, to connect to the sintered layer 20 in the accommodating groove 34.

The positioning portion 32 protrudes from a surface of a side that is of the bottom plate 31 and that faces the power module 10, and a distance at which the positioning portion 32 extends in the thickness direction of the power assembly 100 is less than a height at which the power module 10 extends in the thickness direction. In an assembly process of the power assembly 100, the positioning portion 32 positions the power module 10 and the sintered layer 20, thereby reducing installation precision, and improving installation efficiency of the power assembly 100 and the heat sink 40.

It may be understood that the package body 50 wraps the power module 10, and at least a part of the package body 50 is located in the accommodating groove 34, so that the insulation member 30 positions the package body 50 and the power module 10 in the package body 50 as a whole.

In another implementation, the positioning portion 32 is disposed on a periphery of an outer edge of the bottom plate 31.

The heat sink 40 includes a heat dissipation substrate 41, a heat dissipation fin 42, a housing 43, and a boss 44. The boss 44 protrudes from a surface of a side that is of the heat dissipation substrate 41 and that faces the power module 10. An electrical distance between the heat dissipation substrate 41 and the power module 10 is increased through arrangement of the boss 44, thereby ensuring electrical insulation between the heat dissipation substrate 41 and the lead-out terminal 13. The housing 43 is fastened to a surface of a side that is of the heat dissipation substrate 41 and that is away from the power module 10, the heat dissipation fin 42 is disposed inside the housing 43, and two opposite ends of the heat dissipation fin 42 are respectively fastened to the heat dissipation substrate 41 and the housing 43. The housing 43, the heat dissipation substrate 41, and the heat dissipation fin 42 together form a heat dissipation waterway 45, and coolant is circulated through the heat dissipation waterway 45, to dissipate heat from the power module 10. The heat dissipation substrate 41, the heat dissipation fin 42, and the housing 43 may be connected through hard brazing to form an integrated structure with a complete heat dissipation waterway 45, and no sealing ring needs to be disposed between the heat dissipation substrate 41 and the housing 43 for sealing, thereby avoiding a problem of leakage caused by long-time use of the sealing ring.

The boss 44 and the heat dissipation substrate 41 are integrated, thereby reducing a process of installing the boss 44 on the heat dissipation substrate 41.

The sintered layer 20 is fastened between the boss 44 and the thermally conductive substrate 11, and the power module 10 is connected to the boss 44 through the sintered layer 20. The bottom plate 31 is disposed on the surface of the side that is of the heat dissipation substrate 41 and that faces the power module 10, and the bottom plate 31 is sleeved on a side wall of the boss 44. The boss 44 passes through a through hole 33 of the bottom plate 31 and is connected to the sintered layer 20 in the accommodating groove 34. The bottom plate 31 is located on two opposite sides of the boss 44, and the bottom plates 31 on the two opposite sides of the boss 44 are disposed opposite to at least one lead-out terminal 13 in the thickness direction of the power assembly 100. The bottom plate 31 may be used to electrically insulate a part that is of the heat dissipation substrate 41 and on which no boss 44 is disposed from the lead-out terminal 13.

When the sintered layer 20 is sintered and connected to the boss 44, sintering pressure of a sintered surface is more uniform. Compared to connecting the surface of the side that is of the heat dissipation substrate 41 and that faces the power module 10 to the sintered layer 20, it is easier to control flatness of the sintered surface of the boss 44.

Refer to FIG. 3 and FIG. 4. A chamfer 441 is disposed on an outer edge of the boss 44. When the boss 44 is connected to the sintered layer 20, an excessive part of the sintered layer 20 may flow from the chamfer 441 to a side of the boss 44, to prevent the excessive part of the sintered layer 20 from flowing to the power module 10, and reduce impact of sintered connection on the power module 10. In addition, the chamfer 441 is disposed to allow for a thicker weld at an edge at which the boss 44 is connected to the sintered layer 20, thereby improving reliability of connection between the boss 44 and the sintered layer 20.

In addition, if the boss 44 is directly fastened to the thermally conductive substrate 11, such as through welding, the chamfer 441 of the boss 44 can effectively prevent an excess solder from flowing to the power module 10, thereby reducing impact of welding on the power module 10.

In an implementation, in an arrangement direction of the heat dissipation substrate 41 and the boss 44, a thickness of the insulation member 30 is less than a height of the boss 44. Specifically, a thickness of the bottom plate 31 is less than the height of the boss 44, so that a part of the boss 44 can extend into the accommodating groove 34. This facilitates connection between a surface of a side that is of the boss 44 and that faces the power module 10 and the sintered layer 20 in the accommodating groove 34.

In an implementation, in the arrangement direction of the heat dissipation substrate 41 and the boss 44, the height of the boss 44 is greater than or equal to 0.5 mm and less than or equal to 5 mm. For example, the height of the boss 44 is denoted as H2, and a value of the height H2 of the boss 44 may be 0.5 mm, 0.8 mm, 1.5 mm, 2.0 mm, 2.5 mm, 3.1 mm, 3.7 mm, 4.3 mm, 4.8 mm, or 5.0 mm, which is not listed one by one.

If the height of the boss 44 is less than 0.5 mm, the height of the boss 44 is excessively small, which increases processing difficulty. In addition, the excessively small height of the boss 44 is prone to causing low connection reliability after sintering. If the height of the boss 44 is greater than 5 mm, the height of the boss 44 is excessively large, which causes an increase in thermal resistance between the heat dissipation substrate 41 and the power module 10. In this application, the height of the boss 44 is set to be greater than or equal to 0.5 mm and less than or equal to 5 mm, to reduce impact of the height of the boss 44 on a processing difficulty. This helps improve reliability of connection between the boss 44 and the sintered layer 20, and reduce impact of an excessively large height of the boss 44 on thermal resistance between the heat dissipation substrate 41 and the power module 10.

A coating may be applied to the surface of the boss 44. Specifically, the coating may be applied to the surface of the boss 44 by using a method such as chemical plating or electroplating. A coating material may be any one of Sn, Ag, or Au.

In an implementation, in the thickness direction of the power assembly 100, a projected area of the boss 44 is less than or equal to a projected area of the thermally conductive substrate 11.

The package body 50 is disposed on an outer edge of the thermally conductive substrate 11, and a surface of a side that is of the package body 50 and that faces the heat sink 40 and a surface of a side that is of the thermally conductive substrate 11 and that faces the heat sink 40 are basically on a same surface. When the boss 44 is directly fastened to the thermally conductive substrate 11, if the projected area of the boss 44 is greater than the projected area of the thermally conductive substrate 11, a part of the boss 44 that exceeds the thermally conductive substrate 11 squeezes the package body 50, and damages sealing of the power module 10 by the package body 50. If the projected area of the boss 44 is less than or equal to the projected area of the thermally conductive substrate 11, when the boss 44 is directly connected to the thermally conductive substrate 11, squeezing on the package body 50 can be reduced, and sealing of the power module 10 by the package body 50 can be ensured.

A protruding portion 51 is formed on an outer edge of the package body 50, the lead-out terminal 13 protrudes from the protruding portion 51, and there is a specific distance between a position at which the lead-out terminal 13 protrudes from the protruding portion 51 and an edge of the protruding portion 51.

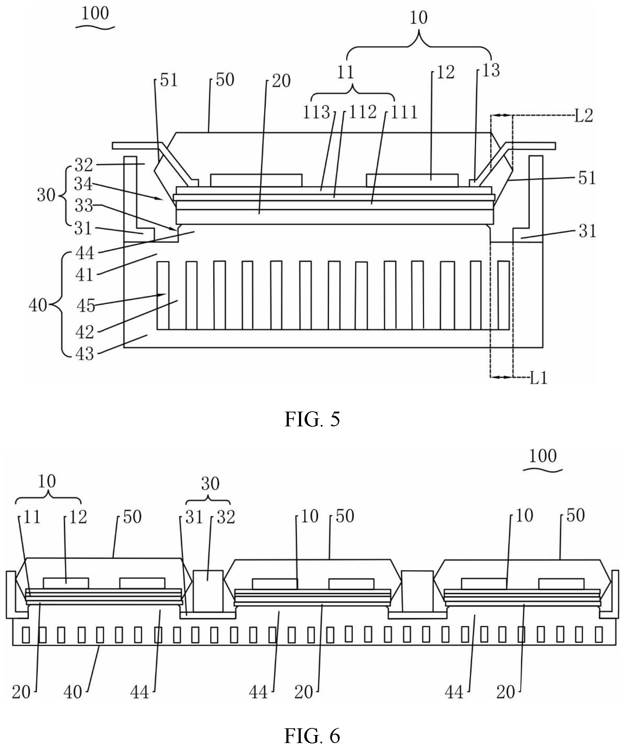

FIG. 5 is a diagram of a structure of a power assembly 100 of another single-sided heat dissipation structure according to an embodiment of this application. In an implementation, in an arrangement direction of the boss 44 and the bottom plate 31, the protruding portion 51 protrudes along a side away from the boss 44, and a spacing between the boss 44 and the bottom plate 31 is less than or equal to a length of the protruding portion 51 protruding along the side away from the boss 44. For example, in the arrangement direction of the boss 44 and the bottom plate 31, the spacing between the boss 44 and the bottom plate 31 is denoted as L1, and the length of the protruding portion 51 protruding along the side away from the boss 44 is denoted as L2, as shown in FIG. 5.

In the arrangement direction of the boss 44 and the bottom plate 31, the spacing L1 between the boss 44 and the bottom plate 31 is a spacing between a surface of a side that is of the bottom plate 31 and that faces the boss 44 and an outer circumferential surface of a side that is of the boss 44 and that faces the bottom plate 31. The length L2 of the protruding portion 51 protruding along the side away from the boss 44 is a distance at which the protruding portion 51 protrudes relative to the outer circumferential surface of the side that is of the boss 44 and that faces the bottom plate 31.

When the spacing L1 between the boss 44 and the bottom plate 31 is equal to the length L2 of the protruding portion 51 protruding along the side away from the boss 44, the protruding portion 51 and the bottom plate 31 together implement electrical insulation for the lead-out terminal 13 and the heat sink 40. In addition, in a thickness direction of the power assembly 100, a projection of the bottom plate 31 on the heat sink 40 does not overlap a projection that is of the protruding portion 51 on the heat sink 40 and whose length is L2. This reduces a quantity of disposed bottom plates 31 and effectively reduces manufacturing costs.

When the spacing L1 between the boss 44 and the bottom plate 31 is less than the length L2 of the protruding portion 51 protruding along the side away from the boss 44, as shown in FIG. 3, the surface of the side that is of the bottom plate 31 and that faces the boss 44 is attached to the outer circumferential surface of the boss 44. In a thickness direction of the power assembly 100, a projection of the bottom plate 31 on the heat sink 40 partially overlaps a projection that is of the protruding portion 51 on the heat sink 40 and whose length is L2, to further enhance electrical insulation performance between the lead-out terminal 13 and the heat sink 40.

A positioning portion 32 on an outer edge of the insulation member 30 surrounds the protruding portion 51, so that the positioning portion 32 can better position the package body 50 as a whole.

FIG. 6 is a diagram of a structure of a power assembly 100 of still another single-sided heat dissipation structure according to an embodiment of this application. The power assembly 100 includes a power module 10, a sintered layer 20, an insulation member 30, a heat sink 40, and a package body 50. There are a plurality of power modules 10. Each power module 10 is encapsulated by one package body 50. Each power module 10 includes a thermally conductive substrate 11, a chip 12, and a lead-out terminal 13 (as shown in FIG. 3). Each power module 10 is correspondingly connected to one boss 44 through one sintered layer 20. A plurality of bosses 44 are disposed on the heat dissipation substrate 41 at intervals. This is specifically determined based on a position of the thermally conductive substrate 11 on the power module 10. A positioning portion 32 is disposed between two adjacent power modules 10, so that the power module 10 is positioned by using the positioning portion 32.

In this embodiment, structures of the power module 10, the sintered layer 20, and the package body 50 are the same as the structures of the corresponding power module 10, sintered layer 20, and package body 50 in the power module 10 shown in FIG. 3 or FIG. 5. Details are not described again. A structure of the heat sink 40 is similar to the structure of the heat sink 40 shown in FIG. 3 or FIG. 5, and a difference lies in that a plurality of bosses 44 are disposed on the heat dissipation substrate 41. A structure of the insulation member 30 is similar to the structure of the insulation member 30 shown in FIG. 3, and a difference lies in that a plurality of positioning portions 32 and a plurality of through holes 33 are disposed on the bottom plate 31 at intervals, and a quantity of the through holes 33 is the same as a quantity of the power modules 10.

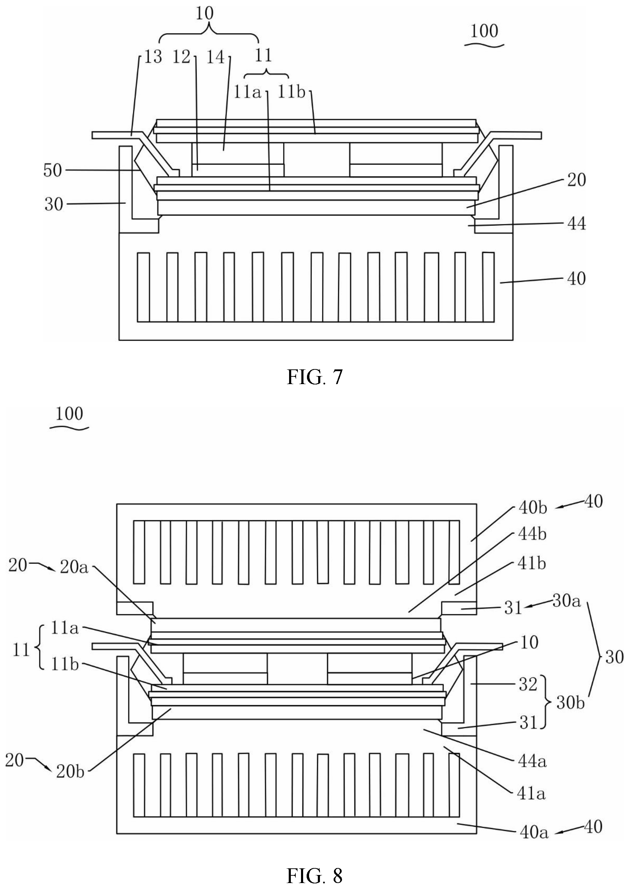

FIG. 7 is a diagram of a structure of a power assembly 100 of a double-sided heat dissipation structure according to an embodiment of this application. As shown in FIG. 7, the power assembly 100 includes a power module 10, a sintered layer 20, an insulation member 30, a heat sink 40, and a package body 50. In this embodiment, there is one power module 10.

The power module 10 includes a first thermally conductive substrate 11a, a second thermally conductive substrate 11b, a chip 12, a lead-out terminal 13, and an interconnection column 14. In a thickness direction of the power assembly 100, the first thermally conductive substrate 11a and the second thermally conductive substrate 11b are disposed on two opposite sides of the chip 12. The first thermally conductive substrate 11a is fastened to the chip 12, and the second thermally conductive substrate 11b is fastened to the chip 12 through the interconnection column 14. The interconnection column 14 plays a role of heat conduction and stress buffering. The lead-out terminal 13 is connected to the first thermally conductive substrate 11a or the second thermally conductive substrate 11b, and dissipates heat for the power module 10 through the first thermally conductive substrate 11a and the second thermally conductive substrate 11b. This improves a heat dissipation capability and heat dissipation efficiency of the power module 10.

The thermally conductive substrate 11 includes the first thermally conductive substrate 11a and the second thermally conductive substrate 11b. The first thermally conductive substrate 11a and the second thermally conductive substrate 11b have a same structure. The first thermally conductive substrate 11a or the second thermally conductive substrate 11b is connected to the boss 44 in the heat sink 40 through the sintered layer 20. In other words, the heat sink 40 is disposed only on one side of the power module 10, heat is dissipated from the side of the power module 10 through the heat sink 40, and heat is dissipated from the other side of the power module 10 through the first thermally conductive substrate 11a or the second thermally conductive substrate 11b. For example, the first thermally conductive substrate 11a is connected to the boss 44 through the sintered layer 20, heat is dissipated from the first thermally conductive substrate 11a through the sintered layer 20 and the heat sink 40 by liquid cooling, and heat is dissipated from the second thermally conductive substrate 11b through air outside of the power assembly 100. Heat generated by the power module 10 is conducted to the outside of the power assembly 100 through the first thermally conductive substrate 11a, the sintered layer 20, and the heat sink 40, and is directly conducted to the outside of the power assembly 100 through the second thermally conductive substrate 11b. This facilitates heat exchange between the second thermally conductive substrate 11b and air, and further improves a heat dissipation capability and heat dissipation efficiency of the power module 10.

It may be understood that, when the first thermally conductive substrate 11a is connected to the heat sink 40, a surface of a side that is of the first thermally conductive substrate 11a and that is away from the second thermally conductive substrate 11b is exposed from the package body 50. A surface of a side that is of the second thermally conductive substrate 11b and that is away from the first thermally conductive substrate 11a may be exposed from the package body 50, or may not be exposed from the package body 50. Preferably, the surface of the side that is of the second thermally conductive substrate 11b and that is away from the first thermally conductive substrate 11a is exposed from the package body 50. In this way, heat conducted by the second thermally conductive substrate 11b is more quickly conducted to the outside of the power assembly 100, and a possibility that the second thermally conductive substrate 11b damages the package body 50 is reduced.

FIG. 8 is a diagram of a structure of a power assembly 100 of another double-sided heat dissipation structure according to an embodiment of this application. As shown in FIG. 8, the power assembly 100 includes a power module 10, a sintered layer 20, an insulation member 30, a heat sink 40, and a package body 50. The sintered layer 20 includes a first sintered layer 20a and a second sintered layer 20b. The heat sink 40 includes a first heat sink 40a and a second heat sink 40b. The insulation member 30 includes a first insulation member 30a and a second insulation member 30b. Both the first heat sink 40a and the second heat sink 40b are disposed on two opposite sides of the power module 10. The first heat sink 40a is connected to a surface of the power module 10 through the first sintered layer 20a, and the second heat sink 40b is connected to the other surface of the power module 10 through the second sintered layer 20b. The first heat sink 40a and the second heat sink 40b are respectively disposed on the two opposite sides of the power module 10, so that heat dissipation efficiency and a heat dissipation capability of the power module 10 can be improved. In addition, no additional screw is required for fastening between the first heat sink 40a and the power module 10 and for fastening between the second heat sink 40b and the power module 10, thereby simplifying an installation process. In addition, the power module 10 is integrated with the first heat sink 40a and the second heat sink 40b, thereby reducing thermal resistance of an interface and improving a heat dissipation capability of the power module 10. The first insulation member 30a is disposed on a surface of a side that is of the first heat sink 40a and that faces the power module 10, and the second insulation member 30b is disposed on a surface of a side that is of the second heat sink 40b and that faces the power module 10, so that electrical insulation is implemented between the first heat sink 40a and the power module 10 as well as between the second heat sink 40b and the power module 10.

As shown in FIG. 8, in this embodiment, there is one power module 10.

In this embodiment, a structure of the power module 10 is the same as the structure of the power module 10 shown in FIG. 7. To be specific, both the power modules 10 include the first thermally conductive substrate 11a and the second thermally conductive substrate 11b; and the first thermally conductive substrate 11a is fastened to the first heat sink 40a through the first sintered layer 20a. A difference lies in that the second thermally conductive substrate 11b is connected to the second heat sink 40b through the second sintered layer 20b, so that a heat dissipation capability and heat dissipation efficiency of the power module 10 is further improved through the second heat sink 40b.

It may be understood that a structure of the first heat sink 40a is the same as a structure of the second heat sink 40b, and the specific structure is the same as the structure of the heat sink of the power assembly 100 shown in FIG. 1. The first heat sink 40a includes a first boss 44a, the second heat sink 40b includes a second boss 44b, the first boss 44a is fastened to the first thermally conductive substrate 11a through the first sintered layer 20a, and the second boss 44b is fastened to the second thermally conductive substrate 11b through the second sintered layer 20b. This increases an electrical distance between the first heat sink 40a and the power module 10 as well as an electrical distance between the second heat sink 40b and the power module 10, and ensures electrical insulation between the first heat sink 40a and the lead-out terminal 13 as well as electrical insulation between the second heat sink 40b and the lead-out terminal 13.

Materials for manufacturing the first sintered layer 20a and the second sintered layer 20b may be the same or may be different. The first sintered layer 20a and the second sintered layer 20b may be sintered simultaneously or in steps.

Materials for manufacturing the first insulation member 30a and the second insulation member 30b may be the same or may be different. This is not specifically limited. A structure of the first insulation member 30a is the same as the structure of the insulation member 30 in the power assembly 100 shown in FIG. 1. To be specific, the bottom plate 31 and the positioning portion 32 are disposed on both the structures; and the positioning portion 32 is located on the two opposite sides of the power module 10. The second insulation member 30b is disposed opposite to the first insulation member 30a. The second insulation member 30b includes only the bottom plate 31. The bottom plate 31 of the second insulation member 30b electrically insulates the second heat sink 40b from the lead-out terminal 13 of the power module 10, so that the power module 10 does not need to be positioned by using the second insulation member 30b. This reduces manufacturing costs of the second insulation member 30b.

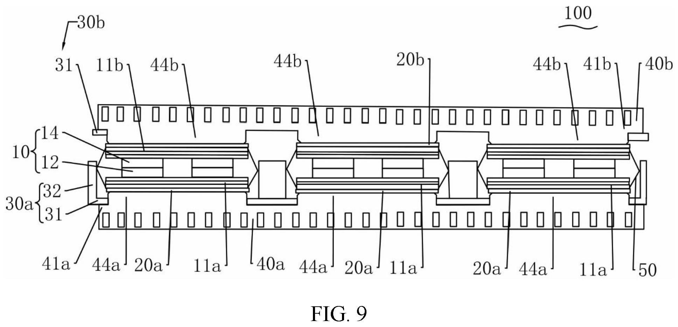

FIG. 9 is a diagram of a structure of a power assembly 100 of still another double-sided heat dissipation structure according to an embodiment of this application. As shown in FIG. 9, the power assembly 100 includes a power module 10, a first sintered layer 20a, a second sintered layer 20b, a first insulation member 30a, a second insulation member 30b, a first heat sink 40a, a second heat sink 40b, and a package body 50. There are a plurality of power modules 10. Each power module 10 is encapsulated by one package body 50. Each power module 10 includes a first thermally conductive substrate 11a, a second thermally conductive substrate 11b, a chip 12, a lead-out terminal 13, and an interconnection column 14. The chip 12 and the lead-out terminal 13 (as shown in FIG. 8) are fastened to the first thermally conductive substrate 11a. The interconnection column 14 is connected to the chip 12 and the second thermally conductive substrate 11b. In each power module 10, the first thermally conductive substrate 11a is correspondingly connected to one first boss 44a through one first sintered layer 20a. A plurality of first bosses 44a are disposed on the first heat dissipation substrate 41a at intervals. This is specifically determined based on a position of the first thermally conductive substrate 11a on the power module 10. The second thermally conductive substrate 11b is correspondingly connected to one second boss 44b through one second sintered layer 20b. A plurality of second bosses 44b are disposed on the second heat dissipation substrate 41b at intervals. This is specifically determined based on a position of the second thermally conductive substrate 11b on the power module 10. A positioning portion 32 of the first insulation member 30a is disposed between two adjacent power modules 10, so that the power module 10 is positioned by using the positioning portion 32 of the first insulation member 30a.

In this embodiment, structures of the power module 10, the first sintered layer 20a, the second sintered layer 20b, and the package body 50 are the same as the structures of the corresponding power module 10, first sintered layer 20a, second sintered layer 20b, and package body 50 in the power assembly 100 shown in FIG. 8. Details are not described again. Structures of the first heat sink 40a and the second heat sink 40b are similar to the structures of the corresponding first heat sink 40a and second heat sink 40b shown in FIG. 7, and a difference lies in that: The plurality of first bosses 44a are disposed on the first heat dissipation substrate 41a, and the plurality of second bosses 44b are disposed on the second heat dissipation substrate 41b. Structures of the first insulation member 30a and the second insulation member 30b are similar to the structures of the corresponding first insulation member 30a and second insulation member 30b shown in FIG. 8, and a difference lies in that: The plurality of through holes 33 are spaced apart on both the bottom plate 31 of the first insulation member 30a and the bottom plate 31 of the second insulation member 30b, a quantity of the through holes 33 is the same as a quantity of the power modules 10. In addition, a plurality of positioning portions 32 are spaced apart on the first insulation member 30a.

A method for manufacturing the power assembly 100 provided in this application is described as follows.

Coatings are applied to a surface of a side that is of the thermally conductive substrate 11 and that faces the heat sink 40 as well as a surface of a side that is of the boss 44 and that faces the power module 10 by using a chemical plating or electroplating method. The heat sink 40 is positioned by using a lower mold of a dedicated sintering mold or a jig, and the insulation member 30 is placed on the heat dissipation substrate 41 along an outer edge of the boss 44. The sintered layer 20 is applied to the thermally conductive substrate 11 or the boss 44 through screen printing or equipment spraying/dot coating. After the sintered layer 20 is applied, pre-drying processing may be performed on the sintered layer 20. Then, the power module 10 is attached, and the power module 10 is positioned by using the insulation member 30, to prevent the thermally conductive substrate 11 of the power module 10 from shifting relative to the boss 44. An upper mold of the sintering mold or a pressure jig is placed for sintering in dedicated equipment. A sintering temperature is less than or equal to 230°C, and a sintering pressure is less than or equal to 15 MPa. The sintering temperature is set to less than or equal to 230°C, so that thermal damage to the power module 10 can be reduced. The sintering pressure is less than or equal to 15 MPa, so that pressure on the thermally conductive substrate 11 during pressure application in a sintering process can be reduced, and a risk of cracking inside the thermally conductive substrate 11 is reduced.

It may be understood that, after the sintered layer 20 is applied, pre-drying processing may not be performed. This may be specifically determined based on a material and a process condition of the sintered layer.

In a motor controller 210 in this application, the power assembly 100 provided in this application is used. The power assembly 100 has better electrical insulation performance and a better heat dissipation capability, so that the motor controller 210 can have a higher current output capability under a same voltage, thereby improving power conversion efficiency of the motor controller 210. In the power module 10, integration between the power module 10 and the heat sink is implemented through the sintered layer, so that a size of the motor controller 210 can be correspondingly reduced, thereby improving power density of the motor controller 210.

In a powertrain 200 in this application, the motor controller 210 provided in this application is used. The motor controller 210 has a higher current output capability, a smaller size, and a reduced weight, so that output power and power density of the powertrain 200 can be increased, and higher electric energy can be provided for the motor 220. This enables the motor 220 to output higher kinetic energy, and the powertrain 200 to have a higher driving force.

In a vehicle 1000 in this application, the powertrain 200 provided in this application is used. The powertrain 200 can provide a higher driving force, so that the vehicle 1000 has greater power, thereby providing better driving experience for a driver.

In this application, unless otherwise specified and limited, terms "connection", "fastened", and the like should be understood in a broad sense. For example, "fastened" may be a fixed connection, may be a detachable connection, or may be an integrated connection; may be a mechanical connection, or may be an electrical connection; or may be a direct connection, or may be an indirect connection through an intermediate medium, or may be a connection inside two elements or an interaction relationship between two elements, unless otherwise specified. A person of ordinary skill in the art may understand specific meanings of the foregoing terms in this application based on a specific case.

"First", "second", and various numbers in this specification are merely used for differentiation for ease of description, but are not intended to limit the scope of this application.

It should be understood that sequence numbers of the foregoing processes do not mean execution sequences in various embodiments of this application. The execution sequences of the processes should be determined according to functions and internal logic of the processes, and should not be construed as any limitation on the implementation processes of embodiments of this application.

The foregoing embodiments are merely intended for describing the technical solutions of this application other than limiting this application. Although this application is described in detail with reference to the foregoing embodiments, a person of ordinary skill in the art should understand that modifications may still be made to the technical solutions described in the foregoing embodiments or equivalent replacements may still be made to some technical features thereof, without departing from the scope of the technical solutions of embodiments of this application.

## Claims

1. A power assembly, wherein the power assembly comprises a power module, a heat sink, and an insulation member, the power module comprises a lead-out terminal, the insulation member is disposed on a surface of a side that is of the heat sink and that faces the power module, and in a thickness direction of the power assembly, a projection of the insulation member covers a projection of the lead-out terminal on the heat sink.

2. The power assembly according to claim 1, wherein the insulation member comprises a bottom plate and a positioning portion, one end of the positioning portion is connected to the bottom plate, the other end of the positioning portion extends in a direction away from the bottom plate, and the bottom plate and the lead-out terminal are disposed opposite to each other in the thickness direction of the power assembly; and
the positioning portion and the bottom plate enclose an accommodating groove, and the accommodating groove accommodates at least a part of the power module.

3. The power assembly according to claim 2, wherein the heat sink comprises a heat dissipation substrate and a boss, the boss protrudes from a surface of a side that is of the heat dissipation substrate and that faces the power module, and the bottom plate is disposed on the surface of the side that is of the heat dissipation substrate and that faces the power module and is located on two opposite sides of the boss.

4. The power assembly according to claim 3, wherein in an arrangement direction of the heat dissipation substrate and the boss, a thickness of the insulation member is less than a height of the boss.

5. The power assembly according to claim 3 or 4, wherein the power assembly further comprises a sintered layer, the sintered layer is fastened between the boss and the power module, and the sintered layer is accommodated in the accommodating groove.

6. The power assembly according to claim 5, wherein the power assembly further comprises a package body, the package body wraps the power module, and at least a part of the package body is located in the accommodating groove.

7. The power assembly according to claim 6, wherein a protruding portion is formed on an outer edge of the package body, in an arrangement direction of the boss and the bottom plate, the protruding portion protrudes along a side away from the boss, and a spacing between the boss and the bottom plate is less than or equal to a length of the protruding portion protruding along the side away from the boss.

8. The power assembly according to claim 6 or 7, wherein the power module comprises a chip and a thermally conductive substrate, the chip is disposed on a side that is of the thermally conductive substrate and that is away from the heat sink, a surface of a side that is of the thermally conductive substrate and that faces the sintered layer is exposed from the package body, and the sintered layer is fastened between the thermally conductive substrate and the boss.

9. The power assembly according to claim 8, wherein in the thickness direction of the power assembly, a projected area of the boss is less than or equal to a projected area of the thermally conductive substrate.

10. The power assembly according to claim 8 or 9, wherein the thermally conductive substrate comprises a first thermally conductive layer, a thermally conductive insulation layer, and a second thermally conductive layer that are sequentially stacked, and a material for manufacturing the thermally conductive insulation layer comprises a thermally conductive insulation sheet or a thermally conductive insulation film.

11. The power assembly according to any one of claims 8 to 10, wherein the thermally conductive substrate comprises a first thermally conductive substrate and a second thermally conductive substrate, the first thermally conductive substrate and the second thermally conductive substrate are respectively disposed on two opposite sides of the chip, and the first thermally conductive substrate and/or the second thermally conductive substrate are/is connected to the boss through the sintered layer.

12. The power assembly according to claim 11, wherein the heat sink comprises a first heat sink and a second heat sink, the first heat sink comprises a first heat dissipation substrate and a first boss, and the second heat sink comprises a second heat dissipation substrate and a second boss; the first heat dissipation substrate and the second heat dissipation substrate are located on the two opposite sides of the chip, the first boss protrudes from a surface of a side that is of the first heat dissipation substrate and that faces the chip, and the second boss protrudes from a surface of a side that is of the second heat dissipation substrate and that faces the chip; and the sintered layer comprises a first sintered layer and a second sintered layer, wherein the first sintered layer is fastened between the first boss and the first thermally conductive substrate, and the second sintered layer is fastened between the second boss and the second thermally conductive substrate.

13. The power assembly according to claim 12, wherein the insulation member comprises a first insulation member and a second insulation member, the first insulation member is disposed on a surface of a side that is of the first heat sink and that faces the second heat sink, the second insulation member is disposed on a surface of a side that is of the second heat sink and that faces the first heat sink, and the first insulation member or the second insulation member comprises a bottom plate and a positioning portion.

14. The power assembly according to any one of claims 3 to 13, wherein a chamfer is disposed on an outer edge of the boss.

15. A motor controller, comprising a capacitor and the power assembly according to any one of claims 1 to 14, wherein a lead-out terminal of a power module is connected to a thermally conductive substrate of the power module, the capacitor is connected to the power module through the lead-out terminal, and the capacitor is configured to provide a voltage for the power module.
